# EUROPEAN PATENT APPLICATION

(11) **EP 4 560 177 A1**
(43) Date of publication of application: **28.05.2025**
(21) Application number: 24215483.9
(22) Date of filing: 26.11.2024
(51) Int. Cl.: F16M 11/16, F16M 11/22, H04N 5/64, F16M 11/04, F16B 21/08

(54) **DISPLAY DEVICE**

(30) Priority: 27.11.2023 KR 20230166625
(71) Applicant: LG Electronics Inc., Yeongdeungpo-gu Seoul 07336 (KR)
(72) Inventor: JEON, Sungho, 06772 Seoul (KR)
(74) Representative: Vossius & Partner Patentanwälte Rechtsanwälte mbB

(57) **Abstract**

A display device (1) may include a display panel (10), a back cover (50) located at the rear of the display panel, and a stand (100) coupled to the back cover, wherein the stand may include a body (101), a head (103) protruding into the back cover from an upper end (101S) of the body, a first arm (105F) extending downward from one side of the top (103T) of the head, and a second arm (105B) extending downward from the other side of the top of the head, the back cover may include a coupling portion (51) protruding into the back cover from the lower side of the back cover, and the coupling portion may include a first hole (51HF) formed in a side surface of the coupling portion, the first hole allowing a first hook (105Fa) of the first arm to be caught therein, and a second hole (51HB) opposite the first hole, the second hole (51HB) allowing a second hook (105Ba) of the second arm to be caught therein.

## Description

### CROSS-REFERENCE TO RELATED APPLICATION

This application claims the priority benefit of Korean Patent Application No. 10-2023-0166625, filed on November 27, 2023, the disclosures of which is incorporated herein by reference.

### BACKGROUND OF THE INVENTION

### Field of the invention

The present disclosure relates to a display device.

### Description of the Related Art

As the information society has developed, the demand for display devices is increasing in various forms, and accordingly, in recent years, various display devices, such as a liquid crystal display (LCD), a plasma display panel (PDP), an electroluminescent display (ELD), a vacuum fluorescent display (VFD), and an organic light-emitting diode (OLED) display, have been studied and used.

Thereamong, an LCD panel includes a TFT substrate and a color substrate opposite each other in the state in which a liquid crystal layer is interposed therebetween, and may display an image using light provided by a backlight unit. An OLED panel may display an image by depositing an organic material layer capable of emitting light by itself on a substrate on which a transparent electrode is formed.

Recently, a lot of research has been conducted on display devices with stands.

### SUMMARY OF THE INVENTION

An object of the present disclosure is to solve the above and other problems.

Another object of the present disclosure may be to provide a display device in which a stand can be detachably coupled to a back cover without the use of a fastening member, such as a screw.

Another object of the present disclosure may be to provide a structure that can improve the coupling stability of the stand coupled to the back cover.

Another object of the present disclosure may be to provide a structure that can improve the ease of assembly and disassembly of the stand.

A further object of the present disclosure may be to provide various examples of the coupling structure between the back cover and stand.

In accordance with an aspect of the present disclosure for achieving the above and other objects, a display device may include: a display panel, a back cover located behind the display panel and to which the display panel is coupled, and a stand coupled to a lower side of the back cover, wherein the stand may include a body having an upper end supporting the lower side of the back cover, a head protruding into the back cover from the upper end of the body, a first arm extending downward from one side of the top of the head and located in the body, the first arm having a first hook formed at an outer surface of the first arm, and a second arm extending downward from the other side of the top of the head and located in the body, the second arm having a second hook formed at an outer surface of the second arm, the back cover may include a coupling portion protruding into the back cover from the lower side of the back cover, and having an interior space accommodating the head, and the coupling portion may include a first hole formed at a side surface of the coupling portion and to which the first hook is coupled, and a second hole opposite the first hole and to which the second hook is coupled.

### BRIEF DESCRIPTION OF THE DRAWINGS

The above and other objects, features and advantages of the present invention will be more apparent from the following detailed description in conjunction with the accompanying drawings, in which:

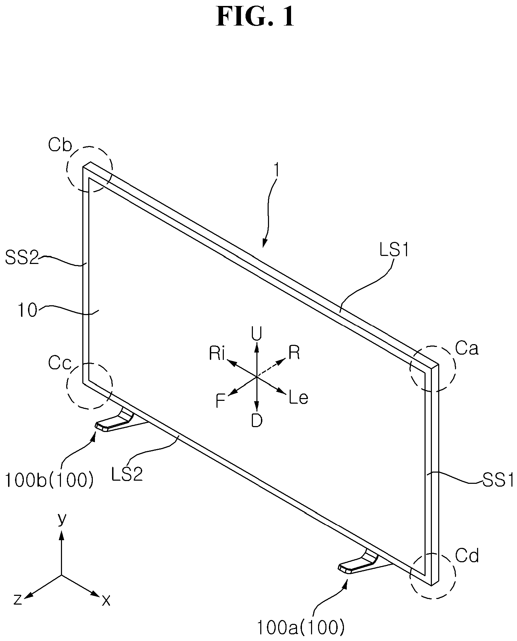

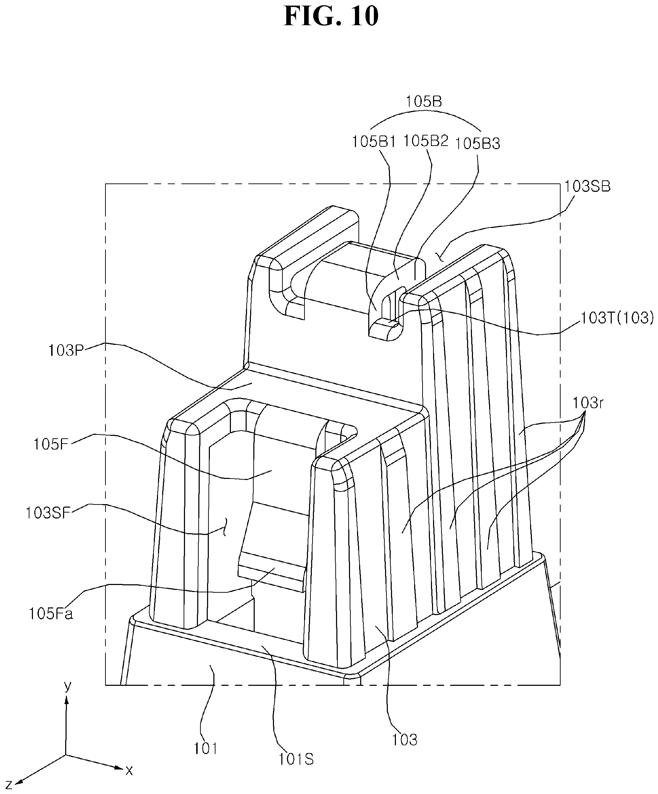

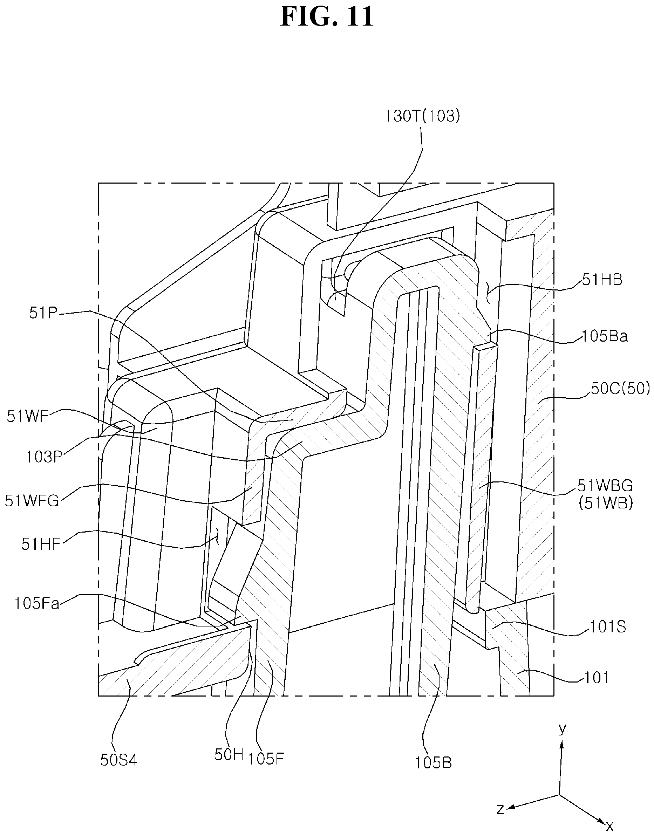

FIGs. 1 to 23 are views showing examples of display devices according to embodiments of the present disclosure.

### DETAILED DESCRIPTION

Hereinafter, the embodiments disclosed in the present specification will be described in detail with reference to the accompanying drawings, and the same or similar elements are denoted by the same reference numerals even though they are depicted in different drawings and redundant descriptions thereof will be omitted.

In the following description, with respect to constituent elements used in the following description, the suffixes "module" and "unit" are used or combined with each other only in consideration of ease in the preparation of the specification, and do not have or serve different meanings.

Also, in the following description of the embodiments disclosed in the present specification, a detailed description of known functions and configurations incorporated herein will be omitted when it may make the subject matter of the embodiments disclosed in the present specification rather unclear. In addition, the accompanying drawings are provided only for a better understanding of the embodiments disclosed in the present specification and are not intended to limit the technical ideas disclosed in the present specification. Therefore, it should be understood that the accompanying drawings include all modifications, equivalents, and substitutions included in the idea and scope of the present disclosure.

Although terms including ordinal numbers, such as "first" and "second," may be used herein to describe various components, these components should not be limited by these terms. These terms are only used to distinguish one component from another component.

It should be understood that, when a component is referred to as being "connected to" or "coupled to" another component, it may be directly connected to or coupled to another component or intervening components may be present. In contrast, it should be understood that, when a component is referred to as being "directly connected to" or "directly coupled to" another component, there are no intervening components present.

Singular forms are intended to include plural forms as well, unless the context clearly indicates otherwise.

In the present application, it should be understood that the terms "includes," "has," etc. specify the presence of stated features, numbers, steps, operations, elements, components, or combinations thereof, but do not preclude the presence or addition of one or more other features, numbers, steps, operations, elements, components, or combinations thereof

Directional designations shown in the drawings, such as upward U, downward D, leftward Le, rightward Ri, forward F, and rearward R, are for illustrative purposes only and are not intended to limit the technical ideas disclosed herein.

Referring to FIG. 1, a display device 1 may include a display panel 10. The display panel 10 may display an image.

The display device 1 may include a first long side LS1, a second long side LS2 opposite the first long side LS1, a first short side SS1 adjacent to the first long side LS1 and the second long side LS2, and a second short side SS2 opposite the first short side SS1. Meanwhile, although the lengths of the first and second long sides LS1 and LS2 are shown and described as being greater than the lengths of the first and second short sides SS1 and SS2 for convenience of description, the lengths of the first and second long sides LS1 and LS2 may be almost equal to the lengths of the first and second short sides SS1 and SS2.

The direction parallel to the long sides LS1 and LS2 may be referred to as a leftward-rightward direction. The direction toward the first short side SS1 may be referred to as a leftward direction Le or x, and the direction toward the second short side SS2 may be referred to as a rightward direction Ri.

The direction parallel to the short sides SS1 and SS2 may be referred to as an upward-downward direction. The direction toward the first long side LS1 may be referred to as an upward direction U or y, and the direction toward the second long side LS2 may be referred to as a downward direction D.

The direction perpendicular to the long sides LS1 and LS2 and the short sides SS1 and SS2 may be referred to as a forward-rearward direction. The direction in which the display panel 10 displays the image may be referred to as a forward direction F or z, and the direction opposite thereto may be referred to as a rearward direction R.

The long sides LS1 and LS2 and the short sides SS1 and SS2 may be referred to as edges of the display device 1. The points at which the long sides LS1 and LS2 and the short sides SS1 and SS2 join with each other may be referred to as corners. A first corner Ca may be the point at which the first short side SS1 and the first long side LS1 join with each other. A second corner Cb may be the point at which the first long side LS1 and the second short side SS2 join with each other. A third corner Cc may be the point at which the second short side SS2 and the second long side LS2 join with each other. A fourth corner Cd may be the point at which the second long side LS2 and the first short side SS1 join with each other.

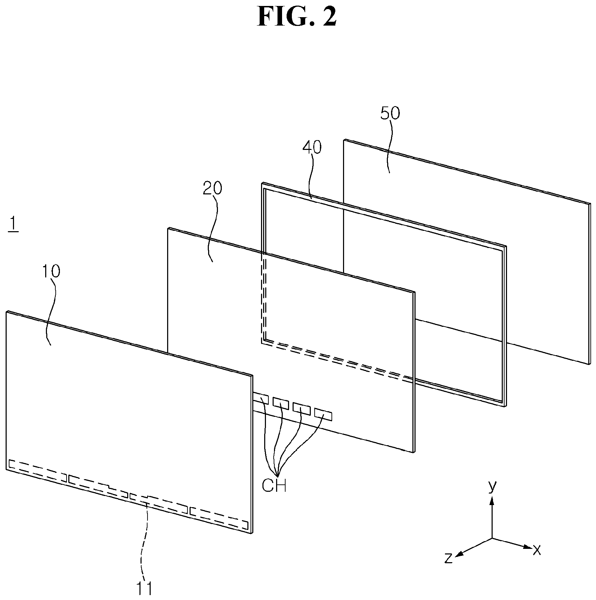

Referring to FIG. 2, the display device 1 may include a display panel 10, a frame 20, a side frame 40, and a back cover 50.

The display panel 10 may form a front surface of the display device 1, and may display an image on the front. The display panel 10 may output an image constituted by a plurality of pixels, and the color, brightness, and saturation of each pixel may be adjusted. The display panel 10 may generate light corresponding to a color of red, green, or blue in response to a control signal. The display panel 10 may be divided into an active area where an image is displayed and a de-active area where no image is displayed. For example, the display panel 10 may be an LCD panel, an LED panel, or an OLED panel. If the display panel 10 is an LCD panel, the display device 1 may include a backlight unit configured to provide light to the display panel 10.

The frame 20 may be located at the rear of the display panel 10, and the display panel 10 may be coupled to the frame 20. For example, the frame 20 may include a metal material. The frame 20 may be referred to as a cover bottom 20, a module cover 20, or a PCB plate 20.

The side frame 40 may extend along the edge of the frame 20, and may be coupled to the frame 20. The side frame 40 may cover the sides of the display panel 10 and the frame 20. The side frame 40 may be referred to as middle cabinet 40 or a guide panel 40.

The back cover 50 may be located at the rear of the frame 20, and may be coupled to the frame 20. The back cover 50 may include a plastic or metal material.

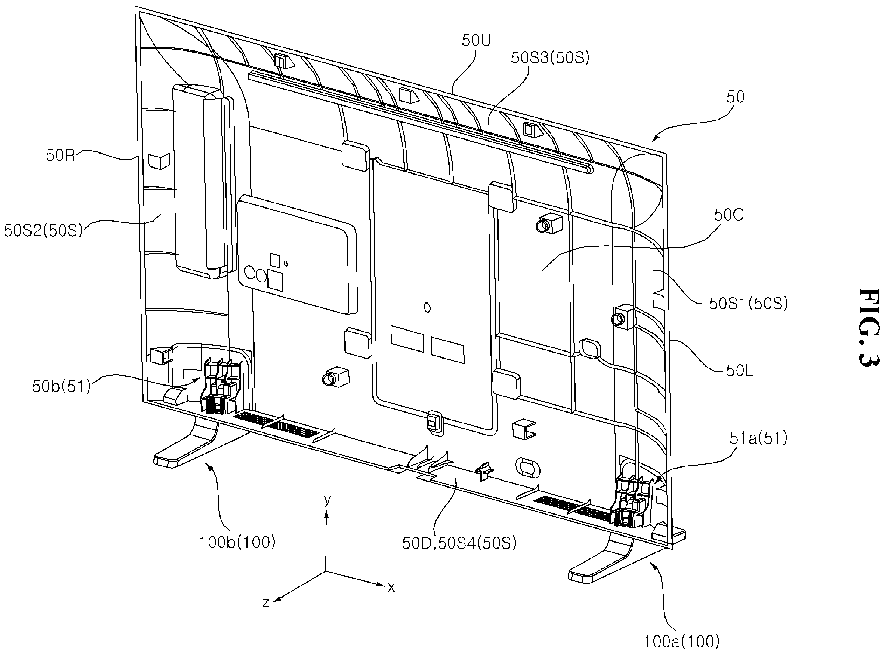

Referring to FIG. 3, the back cover 50 may have an overall quadrangular tray shape. The back cover 50 may include a center portion 50C and side portions 50S.

The center portion 50C may form the center of the back cover 50 and may be flat. A first side portion 50S1 may extend so as to be inclined forward from a left side of the center portion 50C, and may form a left side 50L of the back cover 50. A second side portion 50S2 may extend so as to be inclined forward from a right side of the center portion 50C, and the second side portion 50S2 may form a right side 50R of the back cover 50. A third side portion 50S3 may extend so as to be inclined forward from an upper side of the center portion 50C, and may form an upper side 50U of the back cover 50. A fourth side portion 50S4 may extend so as to be inclined forward from a lower side of the center portion 50C, and may form a lower side 50D of the back cover 50. The fourth side portion 50S4 may be referred to as a base 50S4.

The base 50S4 may be orthogonal to the center portion 50C of the back cover 50 and may extend in a horizontal direction. The base 50S4 may be a part of the back cover 50 in the shape of a thin plate. A coupling portion 51 may protrude upward from an upper surface of the base 50S4. For example, a pair of coupling portions 51a and 51b may be spaced apart from each other in a longitudinal direction (i.e. the leftward-rightward direction) of the base 50S4. In another example, one coupling portion 51 may be formed at a center portion of the base 50S4. In a further example, three or more coupling portions 51 may be spaced apart from each other in the longitudinal direction (i.e. the leftward-rightward direction) of the base 50S4. The coupling portions 51 may be the same as each other. The coupling portion 51 may include a plastic material.

The stand 100 may be located so as to correspond to the coupling portion 51 and may be coupled to the coupling portion 51. For example, each of a pair of stands 100a and 100b may be coupled to a corresponding one of the pair of coupling portions 51a and 51b. In another example, one stand 100 may be coupled to the coupling portion 51 formed at the center portion of the base 50S4. In a further example, each of three or more stands 100 may be coupled to a corresponding one of three or more coupling portions 51. The stands 100 may be the same as each other. The stand 100 may include a plastic material.

The first coupling portion 51a may be formed adjacent to a left end of the base 50S4, and the first stand 100a may be coupled to the first coupling portion 51a. The second coupling portion 51b may be formed adjacent to a right end of the base 50S4, and the second stand 100b may be coupled to the second coupling portion 51b.

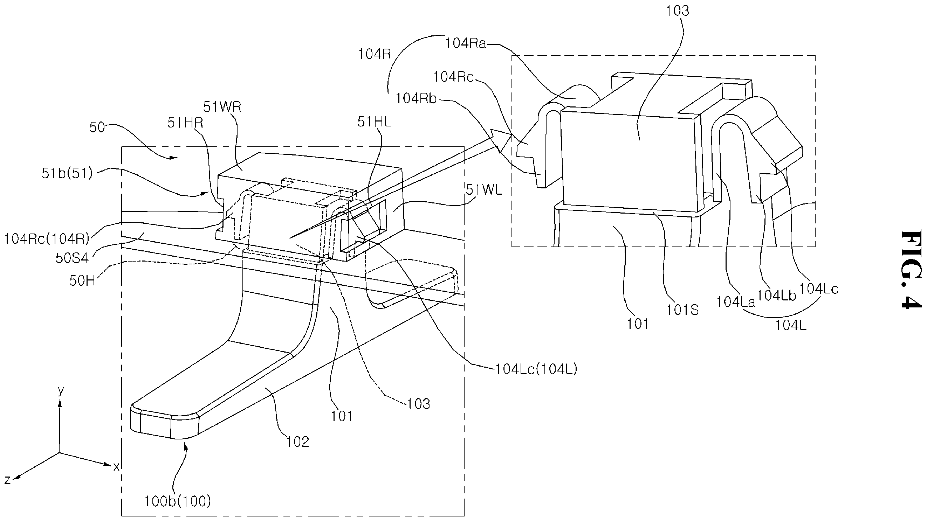

Referring to FIG. 4, the coupling portion 51 may have a block shape protruding upward from the base 50S4, and an interior space of the coupling portion 51 may communicate with a base hole 50H formed in the base 50S4. A left wall 51WL of the coupling portion 51 may form a left surface of the coupling portion 51, and a left hole 51HL may be formed in the left wall 51WL. A right wall 51WR of the coupling portion 51 may form a right surface of the coupling portion 51, and a right hole 51HR may be formed in the right wall 51 WR.

The stand 100 may include a body 101, a leg 102, ahead 103, and arms 104L and 104R.

The body 101 may be located under the base 50S4 and may extend in a direction intersecting the base 50S4. An upper end 101S of the body 101 may support a lower surface of the base 50S4, and may be referred to as a seating portion 101S. The leg 102 may extend from a lower end of the body 101 in a direction intersecting the body 101. The leg 102 may extend forward and rearward, and may rest on the ground. The body 101 and the leg 102 may be collectively referred to as support portions 101 and 102.

The head 103 may protrude upward from the upper end of the body 101 and may be inserted into the interior space of the coupling portion 51 through the base hole 50H of the base 50S4. The head 103 may form a step with respect to the seating portion 101S of the body 101.

The arms 104L and 104R may include a left arm 104L and a right arm 104R. For example, the left arm 104L and right arm 104R may be symmetrical from side to side.

The left arm 104L may be adjacent to a left surface of the head 103, and may include a first part 104La, a second part 104Lb, and a left hook 104Lc. The first part 104La may extend upward from the upper end of the body 101 and may be adjacent to the left surface of the head 103. The second part 104Lb may be bent downward from an upper end of the first part 104La, and may be spaced apart from the first part 104La. The left hook 104Lc may protrude from an outer surface of the second part 104Lb, and may be caught in the left hole 51HL of the left wall 51 WL. The left arm 104L may be elastic.

The left hook 104Lc may have a triangular or trapezoidal longitudinal section. Hypotenuses of the triangular or trapezoidal longitudinal section may face the left hole 51HL, and a bottom side thereof may be caught in a lower end of the left hole 51HL. The left hook 104Lc may be referred to as a left latch 104Lc.

In response to a user's action of inserting the head 103 into the interior space of the coupling portion 51, therefore, the hypotenuses of the left hook 104Lc and the second part 104Lb may be pressed toward the first part 104La by the base hole 50H and the inner surface of the coupling portion 51. Subsequently, when the hypotenuses of the left hook 104Lc face the left hole 51HL, the second part 104Lb may move away from the first part 104La by resilience, and the bottom side of the left hook 104Lc may be caught in the lower end of the left hole 51HL.

In addition, when the user presses the second part 104Lb toward the first part 104La, catching of the left hook 104Lc in the left hole 51HL may be released, and the user may remove the head 103 from the interior space of the coupling portion 51.

The right arm 104R may be adjacent to a right surface of the head 103 and may include a first part 104Ra, a second part 104Rb, and a right hook 104Rc. The first part 104Ramay extend upward from the upper end of the body 101 and may be adjacent to the right surface of the head 103. The second part 104Rb may be bent downward from the upper end of the first part 104Ra, and may be spaced apart from the first part 104Ra. The right hook 104Rc may protrude from an outer surface of the second part 104Rb and may be caught in the right hole 51HR of the right wall 51WR. The right arm 104R may be elastic.

The right hook 104Rc may have a triangular or trapezoidal longitudinal section. Hypotenuses of the triangular or trapezoidal longitudinal section may face the right hole 51HR, and a bottom side thereof may be caught in a lower end of the right hole 51HR. The right hook 104Rc may be referred to as a right latch 104Rc.

In response to a user's action of inserting the head 103 into the interior space of the coupling portion 51, therefore, the hypotenuses of the right hook 104Rc and the second part 104Rb may be pressed toward the first part 104Ra by the base hole 50H and the inner surface of the coupling portion 51. Subsequently, when the hypotenuses of the right hook 104Rc face the right hole 51HR, the second part 104Rb may move away from the first part 104Ra by resilience, and the bottom side of the right hook 104Rc may be caught in the lower end of the right hole 51HR.

In addition, when the user presses the second part 104Rb toward the first part 104Ra, catching of the right hook 104Rc in the right hole 51HR may be released, and the user may remove the head 103 from the interior space of the coupling portion 51.

Accordingly, the stand 100 may be detachably coupled to the back cover 50 without a fastening member such as a screw.

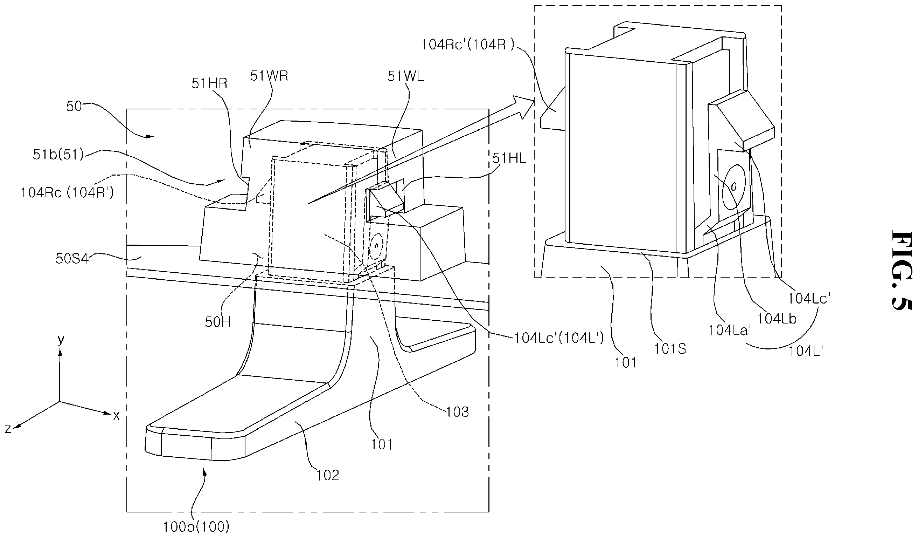

Referring to FIG. 5, the stand 100 may include arms 104L' and 104R' in place of the arms 104L and 104R described above with reference to FIG. 4. The arms 104L and 104R' may include a left arm 104L' and a right arm 104R'. For example, the left arm 104L' and the right arm 104R' may be symmetrical from side to side.

The left arm 104L' may be adjacent to the left surface of the head 103, and may include a first part 104La', a second part 104Lb', and a left hook 104Lc'. The first part 104La' may extend so as to be inclined upward from the upper end of the body 101 and may be adjacent to the left surface of the head 103. The second part 104Lb' may be bent upward from an upper end of the first part 104La', and may be spaced apart from the left surface of the head 103. The left hook 104Lc' may protrude from an outer surface of the second part 104Lb' and may be caught in the left hole 51HL of the left wall 51 WL.

The left hook 104Lc' may have a triangular or trapezoidal longitudinal section. Hypotenuses of the triangular or trapezoidal longitudinal section may face the left hole 51HL, and a bottom side thereof may be caught in a lower end of the left hole 51HL. The left hook 104Lc' may be referred to as a left latch 104Lc'.

In response to a user's action of inserting the head 103 into the interior space of the coupling portion 51, therefore, the hypotenuses of the left hook 104Lc' and the second part 104Lb' may be pressed toward the left surface of the head 103 by the base hole 50H and the inner surface of the coupling portion 51. Subsequently, when the hypotenuses of the left hook 104Lc' face the left hole 51HL, the second part 104Lb' may move away from the left surface of the head 103 by resilience, and the bottom side of the left hook 104Lc' may be caught in the lower end of the left hole 51HL.

In addition, when the user presses the second part 104Lb' toward the left surface of the head 103, catching of the left hook 104Lc' in the left hole 51HL may be released, and the user may remove the head 103 from the interior space of the coupling portion 51.

The right arm 104R' may be adjacent to the right surface of the head 103, and may include a first part 104Ra', a second part 104Rb', and a right hook 104Rc'. The first part 104Ra' may extend so as to be inclined upward from the upper end of the body 101 and may be adjacent to the right surface of the head 103. The second part 104Rb' may be bent upward from an upper end of the first part 104Ra', and may be spaced apart from the right surface of the head 103. The right hook 104Rc' may protrude from an outer surface of the second part 104Rb' and may be caught in the right hole 51HR of the right wall 51WR.

The right hook 104Rc' may have a triangular or trapezoidal longitudinal section. Hypotenuses of the triangular or trapezoidal longitudinal section may face the right hole 51HR, and a bottom side thereof may be caught in a lower end of the right hole 51HR. The right hook 104Rc' may be referred to as a right latch 104Rc'.

In response to a user's action of inserting the head 103 into the interior space of the coupling portion 51, therefore, the hypotenuses of the right hook 104Rc' and the second part 104Rb' may be pressed toward the right surface of the head 103 by the base hole 50H and the inner surface of the coupling portion 51. Subsequently, when the hypotenuses of the right hook 104Rc' face the right hole 51HR, the second part 104Rb' may move away from the right surface of the head 103 by resilience, and the bottom side of the right hook 104Rc' may be caught in the lower end of the right hole 51HR.

In addition, when the user presses the second part 104Rb' toward the right surface of the head 103, catching of the right hook 104Rc' in the right hole 51HR may be released, and the user may remove the head 103 from the interior space of the coupling portion 51.

Accordingly, the stand 100 may be detachably coupled to the back cover 50 without a fastening member such as a screw.

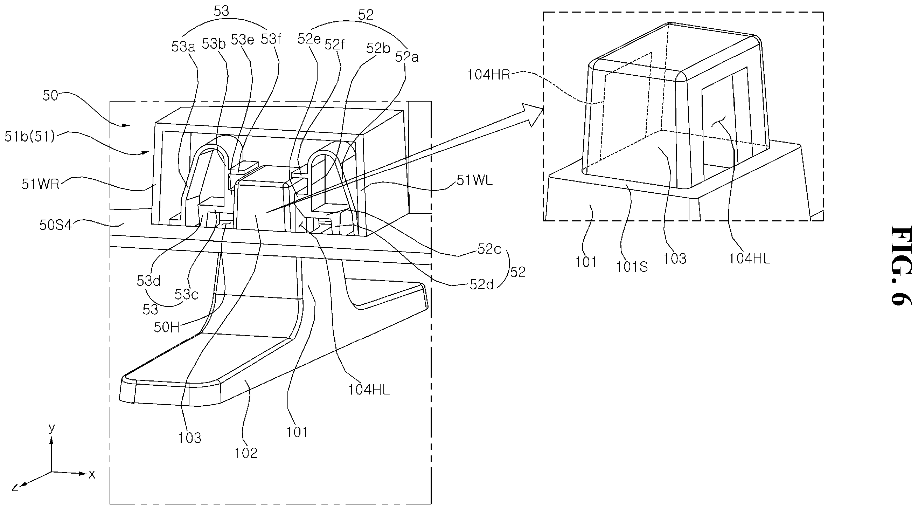

Referring to FIG. 6, the coupling portion 51 may have a block shape protruding upward from the base 50S4, and an interior space of the coupling portion 51 may communicate with the base hole 50H formed in the base 50S4.

The stand 100 may include a body 101, a leg 102, a head 103, and grooves 104HL and 104HR.

The body 101 may be located under the base 50S4 and may extend in a direction intersecting the base 50S4. An upper end 101S of the body 101 may support a lower surface of the base 50S4, and may be referred to as a seating portion 101S. The leg 102 may extend from a lower end of the body 101 in a direction intersecting the body 101. The leg 102 may extend forward and rearward, and may rest on the ground. The body 101 and the leg 102 may be collectively referred to as support portions 101 and 102.

The head 103 may protrude upward from the upper end of the body 101 and may be inserted into the interior space of the coupling portion 51 through the base hole 50H of the base 50S4. The head 103 may form a step with respect to the seating portion 101S of the body 101.

The grooves 104HL and 104HR may include a left groove 104HL and a right groove 104HR. The left groove 104HL may be formed in a left surface of the head 103, and the right groove 104HR may be formed in a right surface of the head 103.

A left holder 52 may be adjacent to the left wall 51WL of the coupling portion 51, and may include a first part 52a, a second part 52b, a third part 52c, a fourth part 52d, and a left hook 52e. The first part 52a may extend so as to be inclined from a left boundary of the base hole 50H into the interior space of the coupling portion 51 and may be adjacent to the left wall 51WL of the coupling portion 51. The second part 52b may be bent downward from an upper end of the first part 52a and may be spaced apart from the first part 52a. The third part 52c may be bent from a lower end of the second part 52b toward the left wall 51 WL. The fourth part 52d may be bent downward from a distal end of the third part 52c and may extend through the base hole 50H. The left hook 52e may protrude from the second part 52b toward the left groove 104HL, and may be caught in the left groove 104HL. The left holder 52 may be elastic.

The left hook 52e may have a triangular or trapezoidal longitudinal section. Hypotenuses of the triangular or trapezoidal longitudinal section may face the left groove 104HL, and a bottom side thereof may be caught in an upper end of the left groove 104HL. Meanwhile, a left rib 52f may be spaced apart from the left hook 52e. The left hook 52e may be referred to as a left latch 52e.

In response to a user's action of inserting the head 103 into the interior space of the coupling portion 51, therefore, the hypotenuses of the left hook 52e and the second part 52b may be pressed toward the first part 52a by the outer surface of the body 101. Subsequently, when the hypotenuses of the left hook 52e face the left groove 104HL, the second part 52b may move away from the first part 52a by resilience, and the bottom side of the left hook 52e may be caught in the upper end of the left groove 104HL.

In addition, when the user presses the second part 52b toward the first part 52a, catching of the left hook 52e in the left groove 104HL may be released, and the user may remove the head 103 from the interior space of the coupling portion 51.

A right holder 53 may be adjacent to the right wall 51WR of the coupling portion 51, and may include a first part 53a, a second part 53b, a third part 53c, a fourth part 53d, and a right hook 53e. The first part 53a may extend so as to be inclined from a right boundary of the base hole 50H into the interior space of the coupling portion 51 and may be adjacent to the right wall 51WR of the coupling portion 51. The second part 53b may be bent downward from an upper end of the first part 53a, and may be spaced apart from the first part 53a. The third part 53c may be bent from a lower end of the second part 53b toward the right wall 51WR. The fourth part 53d may be bent downward from a distal end of the third part 53c and may extend through the base hole 50H. The right hook 53e may protrude from the second part 53b toward the right groove 104HR, and may be caught in the right groove 104HR. The right holder 53 may be elastic.

The right hook 53e may have a triangular or trapezoidal longitudinal section. Hypotenuses of the triangular or trapezoidal longitudinal section may face the right groove 104HR, and a bottom side thereof may be caught in an upper end of the right groove 104HR. Meanwhile, a right rib 53f may be spaced apart from the right hook 53e. The right hook 53e may be referred to as a right latch 53e.

In response to a user's action of inserting the head 103 into the interior space of the coupling portion 51, therefore, the hypotenuses of the right hook 53e and the second part 53b may be pressed toward the first part 53a by the outer surface of the body 101. Subsequently, when the hypotenuses of the right hook 53e face the right groove 104HR, the second part 53b may move away from the first part 53a by resilience, and the bottom side of the right hook 53e may be caught in the upper end of the right groove 104HR.

In addition, when the user presses the second part 53b toward the first part 53a, catching of the right hook 53e in the right groove 104HR may be released, and the user may remove the head 103 from the interior space of the coupling portion 51.

Accordingly, the stand 100 may be detachably coupled to the back cover 50 without a fastening member such as a screw.

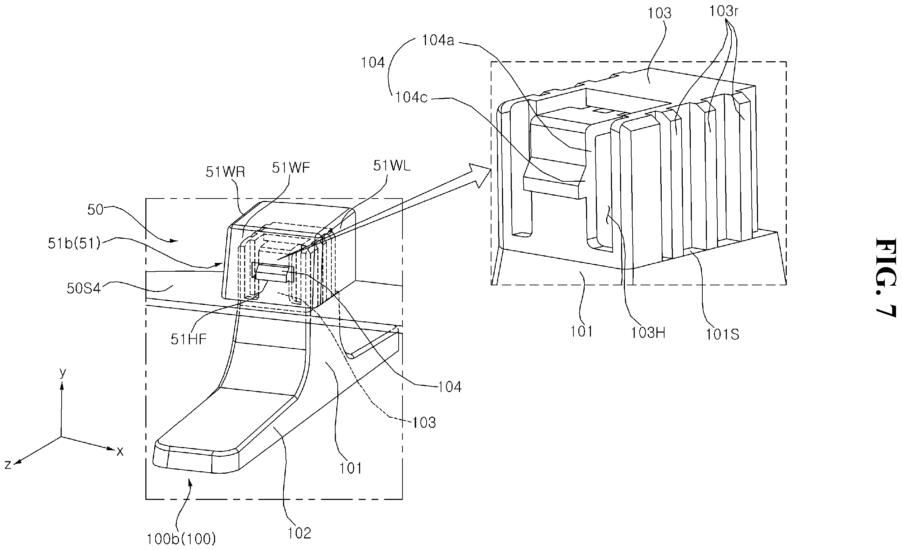

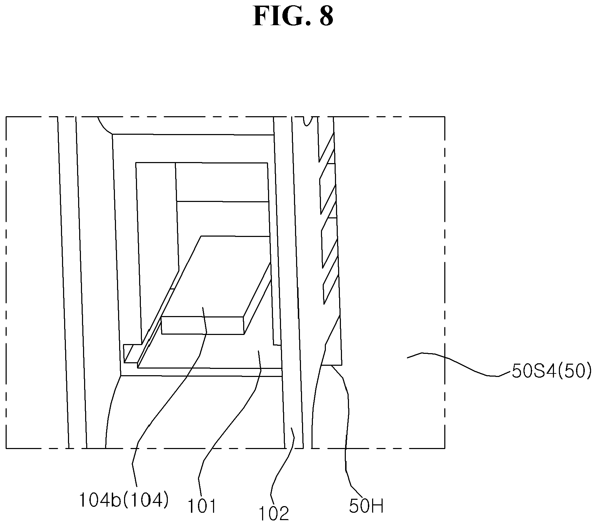

Referring to FIGs. 7 and 8, the coupling portion 51 may have a block shape protruding upward from the base 50S4, and an interior space of the coupling portion 51 may communicate with the base hole 50H. A front wall 51WF of the coupling portion 51 may form a front surface of the coupling portion 51, and a front hole 51HF may be formed in the front wall 51WF.

The stand 100 may include a body 101, a leg 102, a head 103, and an arm 104.

The body 101 may be located under the base 50S4 and may extend in a direction intersecting the base 50S4. An upper end 101S of the body 101 may support a lower surface of the base 50S4, and may be referred to as a seating portion 101S. The leg 102 may extend from a lower end of the body 101 in a direction intersecting the body 101. The leg 102 may extend forward and rearward, and may rest on the ground. The body 101 and the leg 102 may be collectively referred to as support portions 101 and 102.

The head 103 may protrude upward from the upper end of the body 101 and may be inserted into the interior space of the coupling portion 51 through the base hole 50H of the base 50S4. The head 103 may form a step with respect to the seating portion 101S of the body 101. Ribs 103r may be formed on a left surface and a right surface of the head 103, and may be adjacent to the left wall 51 WL and the right wall 51 WR of the coupling portion 51. A hole 103H may be formed in a front surface of the head 103, and may communicate with an interior space of the stand 100.

The arm 104 may be located in the hole 103H of the head 103, and may include a first part 104a, a second part 104b, and a hook 104c. The first part 104a may extend upward from a lower end of the hole 103H and may face the inner surface of the front wall 51WF of the coupling portion 51. The second part 104b may be bent downward from an upper end of the first part 104a, and may be spaced apart from the first part 104a. The second part 104b may be located in the interior space of the stand 100. The hook 104c may protrude from an outer surface of the first part 104a and may be caught in the front hole 51HF of the front wall 51WF. The arm 104 may be elastic.

The hook 104c may have a triangular or trapezoidal longitudinal section. Hypotenuses of the triangular or trapezoidal longitudinal section may face the front hole 51HF, and a bottom side thereof may be caught in a lower end of the front hole 51HF. The hook 104c may be referred to as a latch 104c.

In response to a user's action of inserting the head 103 into the interior space of the coupling portion 51, therefore, the hypotenuses of the hook 104c and the first part 104a may be pressed inwardly of the hole 103H by the base hole 50H and the inner surface of the coupling portion 51. Subsequently, when the hypotenuses of the hook 104c face the front hole 51 HF, the first part 104a may move toward the front wall 51WF by resilience, and the bottom side of the hook 104c may be caught in the lower end of the front hole 51HF.

In addition, when the user presses the second part 104b such that the first part 104a moves away from the front wall 51WF, catching of the hook 104c in the front hole 51HF may be released, and the user may remove the head 103 from the interior space of the coupling portion 51.

Accordingly, the stand 100 may be detachably coupled to the back cover 50 without a fastening member such as a screw.

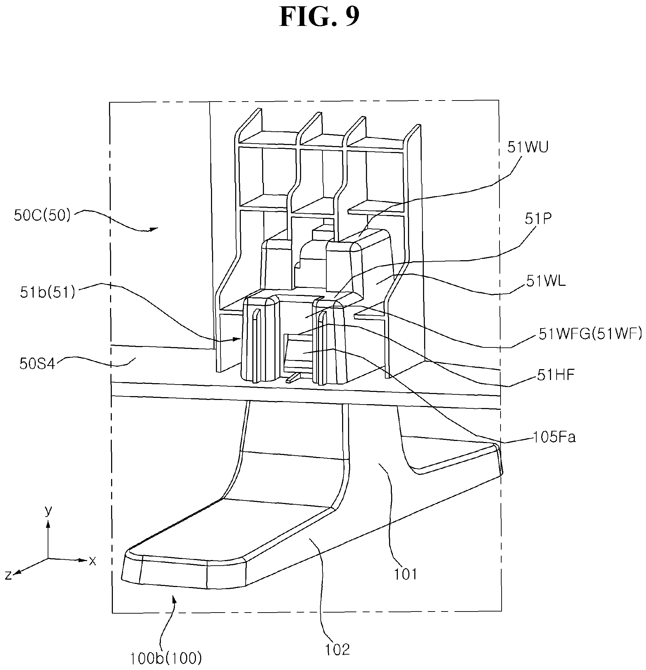

Referring to FIGs. 9 to 12, the coupling portion 51 may have a block shape protruding upward from the base 50S4, and an interior space of the coupling portion 51 may communicate with the base hole 50H. The coupling portion 51 may include a left wall 51WL, a right wall 51WR, a front wall 51WF, a rear wall 51WB, and an upper wall 51WU. The left wall 51WL may form a left surface of the coupling portion 51, and the right wall 51WR may form a right surface of the coupling portion 51. The front wall 51WF may form a front surface of the coupling portion 51, and the rear wall 51WB may form a rear surface of the coupling portion 51. The upper wall 51WU may form an upper surface of the coupling portion 51. A recessed portion 51P may form a step lowered from the upper wall 51WU. A plurality of horizontal ribs and a plurality of vertical ribs may be formed around the coupling portion 51 and may be connected to the coupling portion 51. Consequently, rigidity of the coupling portion 51 may be improved.

A front hole 51HF may be formed in a front groove 51WFG of the front wall 51WF, and a rear hole 51HB may be formed in a rear groove 51WBG of the rear wall 51 WB. For example, the front hole 51HF and the rear hole 51HB may be located at different heights. In another example, the front hole 51HF and the rear hole 51HB may be located at the same height.

The stand 100 may include a body 101, a leg 102, ahead 103, and arms 105F and 105B.

The body 101 may be located under the base 50S4 and may extend in a direction intersecting the base 50S4. An upper end 101S of the body 101 may support a lower surface of the base 50S4, and may be referred to as a seating portion 101S. The leg 102 may extend from a lower end of the body 101 in a direction intersecting the body 101. The leg 102 may extend forward and rearward, and may rest on the ground. The body 101 and the leg 102 may be collectively referred to as support portions 101 and 102.

The head 103 may protrude upward from the upper end of the body 101 and may be inserted into the interior space of the coupling portion 51 through the base hole 50H of the base 50S4. The head 103 may form a step with respect to the seating portion 101S of the body 101. Ribs 103r may be formed on a left surface and a right surface of the head 103, and may be adjacent to or in contact with the left wall 51WL and the right wall 51WR of the coupling portion 51, whereby support stability of the stand 100 may be improved. A front slot 103SF may be formed in a front surface of the head 103, and the front groove 51WFG of the front wall 51WF may be inserted into the front slot 103SF. A rear slot 103SB may be formed in a rear surface of the head 103, and the rear groove 51WBG of the rear wall 51WB may be inserted into the rear slot 103SB. A recessed portion 103P may form a step lowered from an upper surface of the head 103.

The front arm 105F may protrude into the interior space of the stand 100 from the recessed portion 103P, and may extend in the vertical direction. A front hook 105Fa may be formed on the front arm 105F, and may be inserted into the front hole 51HF of the front wall 51WF. The front arm 105F may be elastic. The front arm 105F may be referred to as a first arm 105F, the front hook 105Fa may be referred to as a first hook 105Fa, and the front hole 51HF may be referred to as a first hole 51HF.

The front hook 105Fa may have a triangular or trapezoidal longitudinal section. Hypotenuses of the triangular or trapezoidal longitudinal section may face the front hole 51HF, and a bottom side thereof may be caught in a lower end of the front hole 51HF. The lower end of the front hole 51HF may be formed by an upper surface of the base 50S4. Alternatively, the lower end of the front hole 51HF may be formed by the front wall 51WF. The front hook 105Fa may be referred to as a front latch 105Fa.

In response to a user's action of inserting the head 103 into the interior space of the coupling portion 51, therefore, the hypotenuses of the front hook 105Fa and the front arm 105F may be pressed rearward by the base hole 50H and the front wall 51WF. Subsequently, when the hypotenuses of the front hook 105Fa face the front hole 51HF, the front arm 105F may move forward by resilience, and the bottom side of the front hook 105Fa may be caught in the lower end of the front hole 51HF. An upper surface of the recessed portion 103P may be adjacent to or in contact with a lower surface of the recessed portion 51P. Consequently, the support area of the stand 100 for the coupling portion 51 may be increased.

The rear arm 105B may protrude into the interior space of the stand 100 from the top 103T of the head 103, and may extend in the vertical direction. The rear arm 105B may include a first part 105B1 protruding upward from the top 103T of the head 103, a second part 105B2 bent rearward from an upper end of the first part 105B1, and a third part 105B3 bent downward from a rear end of the second part 105B2. A rear hook 105Ba may be formed at the third part 105B3 of the rear arm 105B, and may be inserted into the rear hole 51HB of the rear wall 51WB. The rear arm 105B may be elastic. The rear arm 105B may be referred to as a second arm 105B, the rear hook 105Ba may be referred to as a second hook 105Ba, and the rear hole 51HB may be referred to as a second hole 51HB.

The rear hook 105Ba may have a triangular or trapezoidal longitudinal section. Hypotenuses of the triangular or trapezoidal longitudinal section may face the rear hole 51HB, and a bottom side thereof may be caught in a lower end of the rear hole 51HB. The lower end of the rear hole 51HB may be formed by the rear wall 51WB. Alternatively, the lower end of the rear hole 51HB may be formed by a rib (not shown) protruding forward from the center portion 50C of the back cover 50. The rear hook 105Ba may be referred to as a rear latch 105Ba.

In response to a user's action of inserting the head 103 into the interior space of the coupling portion 51, therefore, the hypotenuses of the rear hook 105Ba and the rear arm 105B may be pressed forward by the base hole 50H and the rear wall 51 WB. Subsequently, when the hypotenuses of the rear hook 105Ba face the rear hole 51HB, the rear arm 105B may move rearward by resilience, and the bottom side of the rear hook 105Ba may be caught in the lower end of the rear hole 51HB.

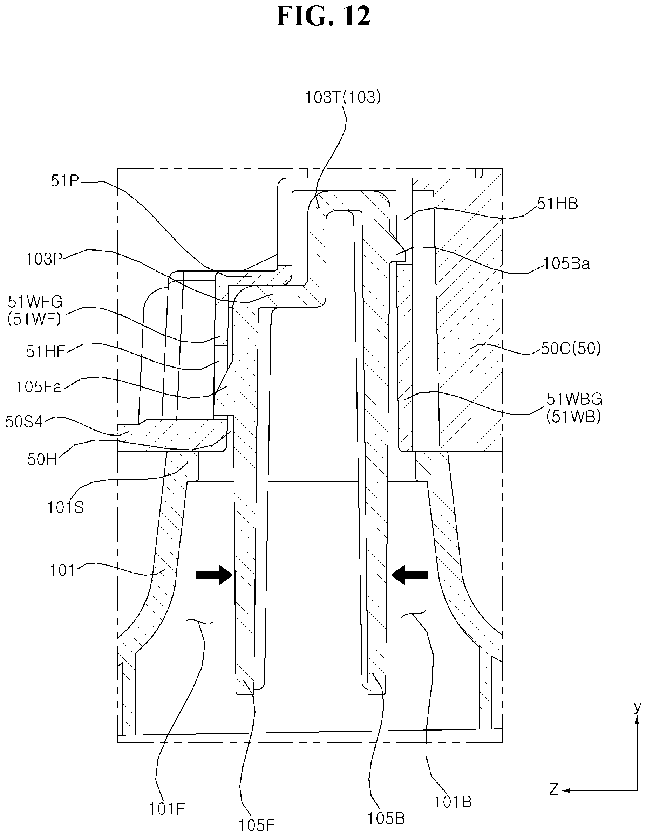

In addition, the user may insert a finger into the space 101F between the inner surface of the body 101 and the front arm 105F and the space 101B between the inner surface of the body 101 and the rear arm 105B, and may move the front arm 105F and the rear arm 105B such that the arms 105F and 105B are close to each other (see arrows in FIG. 12). In this case, catching of the front hook 105Fa in the front hole 51HF may be released, catching of the rear hook 105Ba in the rear hole 51HB may be released, and the user may remove the head 103 from the interior space of the coupling portion 51.

Accordingly, the stand 100 may be detachably coupled to the back cover 50 without a fastening member such as a screw, and may stably support the display device.

For example, the front arm 105F and the rear arm 105B may be aligned with each other in the forward-rearward direction.

In another example, the front arm 105F and the rear arm 105B may be staggered from each other in the forward-rearward direction. In this case, the spaces 101F and 101B may be more easily provided in the body 101 having a predetermined width in the forward-rearward direction than in the case in which the front arm 105F and the rear arm 105B are aligned with each other in the forward-rearward direction.

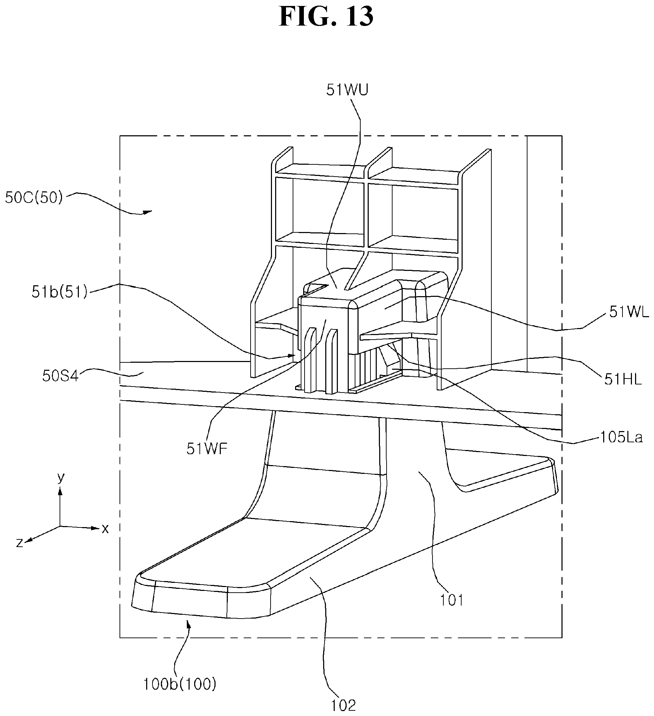

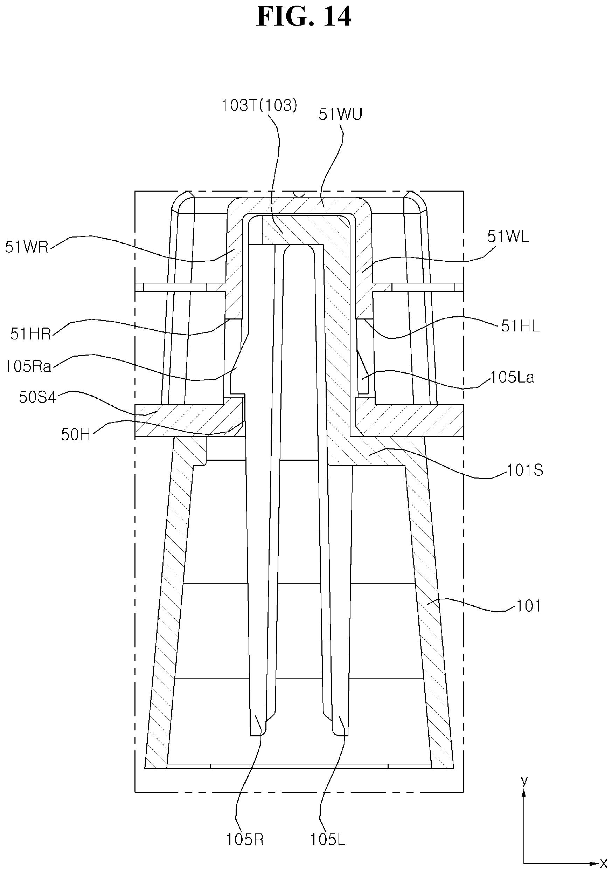

Referring to FIGs. 13 and 14, the coupling portion 51 may have a block shape protruding upward from the base 50S4, and an interior space of the coupling portion 51 may communicate with the base hole 50H. The coupling portion 51 may include a left wall 51WL, a right wall 51WR, a front wall 51WF, a rear wall 51WB, and an upper wall 51WU. The left wall 51WL may form a left surface of the coupling portion 51, and the right wall 51WR may form a right surface of the coupling portion 51. The front wall 51WF may form a front surface of the coupling portion 51, and the rear wall 51WB may form a rear surface of the coupling portion 51. The upper wall 51WU may form an upper surface of the coupling portion 51. A plurality of horizontal ribs and a plurality of vertical ribs may be formed around the coupling portion 51 and may be connected to the coupling portion 51. Consequently, rigidity of the coupling portion 51 may be improved.

A left hole 51HL may be formed in the left wall 51WL, and a right hole 51HR may be formed in the right wall 51WR. For example, the left hole 51HL and the right hole 51HR may be located at the same height. In another example, the left hole 51HL and the right hole 51HR may be located at different heights.

The stand 100 may include a body 101, a leg 102, ahead 103, and arms 105L and 105R.

The body 101 may be located under the base 50S4 and may extend in a direction intersecting the base 50S4. An upper end 101S of the body 101 may support a lower surface of the base 50S4, and may be referred to as a seating portion 101S. The leg 102 may extend from a lower end of the body 101 in a direction intersecting the body 101. The leg 102 may extend forward and rearward, and may rest on the ground. The body 101 and the leg 102 may be collectively referred to as support portions 101, 102.

The head 103 may protrude upward from the upper end of the body 101 and may be inserted into the interior space of the coupling portion 51 through the base hole 50H of the base 50S4. The head 103 may form a step with respect to the seating portion 101S of the body 101.

The left arm 105L may protrude into the interior space of the stand 100 from a left side 103L of the top 103T of the head 103, and may extend in the vertical direction. A left hook 105La may be formed at the left arm 105L, and may be inserted into the left hole 51HL of the left wall 51WL. The left arm 105L may be elastic. The left arm 105L may be referred to as a first arm 105L, the left hook 105La may be referred to as a first hook 105La, and the left hole 51HL may be referred to as a first hole 51HL.

The left hook 105La may have a triangular or trapezoidal longitudinal section. Hypotenuses of the triangular or trapezoidal longitudinal section may face the left hole 51HL, and a bottom side thereof may be caught in a lower end of the left hole 51HL. The lower end of the left hole 51HL may be formed by the upper surface of the base 50S4. Alternatively, the lower end of the left hole 51HL may be formed by the left wall 51WL. The left hook 105La may be referred to as a left latch 105La.

In response to a user's action of inserting the head 103 into the interior space of the coupling portion 51, therefore, the hypotenuses of the left hook 105La and the left arm 105L may be pressed rightward by the base hole 50H and the left wall 51 WL. Subsequently, when the hypotenuses of the left hook 105La face the left hole 51HL, the left arm 105L may move leftward by resilience, and the bottom side of the left hook 105La may be caught in the lower end of the left hole 51HL. An upper surface of the head 103 may be adjacent to or in contact with a lower surface of the upper wall 51WU.

The right arm 105R may protrude into the interior space of the stand 100 from a right side 103R of the top 103T of the head 103, and may extend in the vertical direction. A right hook 105Ra may be formed at the right arm 105R, and may be inserted into the right hole 51HR of the right wall 51WR. The right arm 105R may be elastic. The right arm 105R may be referred to as a second arm 105R, the right hook 105Ra may be referred to as a second hook 105Ra, and the right hole 51HR may be referred to as a second hole 51HR.

The right hook 105Ra may have a triangular or trapezoidal longitudinal section. Hypotenuses of the triangular or trapezoidal longitudinal section may face the right hole 51HR, and a bottom side thereof may be caught in a lower end of the right hole 51HR. The lower end of the right hole 51HR may be formed by the upper surface of the base 50S4. Alternatively, the lower end of the right hole 51HR may be formed by the right wall 51WR. The right hook 105Ra may be referred to as a light latch 105Ra.

In response to a user's action of inserting the head 103 into the interior space of the coupling portion 51, therefore, the hypotenuses of the right hook 105Ra and the right arm 105R may be pressed leftward by the base hole 50H and the right wall 51WR. Subsequently, when the hypotenuses of the right hook 105Ra face the right hole 51HR, the right arm 150R may move rightward by resilience, and the bottom side of the right hook 105Ra may be caught in the lower end of the right hole 51HR. The upper surface of the head 103 may be adjacent to or in contact with the lower surface of the upper wall 51WU.

In addition, the user may insert a finger into the space 101L between the inner surface of the body 101 and the left arm 105L and the space 101R between the inner surface of the body 101 and the right arm 105R, and may move the left arm 105L and the right arm 105R such that the arms 105L and 105R are close to each other (see arrows in FIG. 14). In this case, catching of the left hook 105La in the left hole 51HL may be released, catching of the right hook 105Ra in the right hole 51HR may be released, and the user may remove the head 103 from the interior space of the coupling portion 51.

Accordingly, the stand 100 may be detachably coupled to the back cover 50 without a fastening member such as a screw, and may stably support the display device.

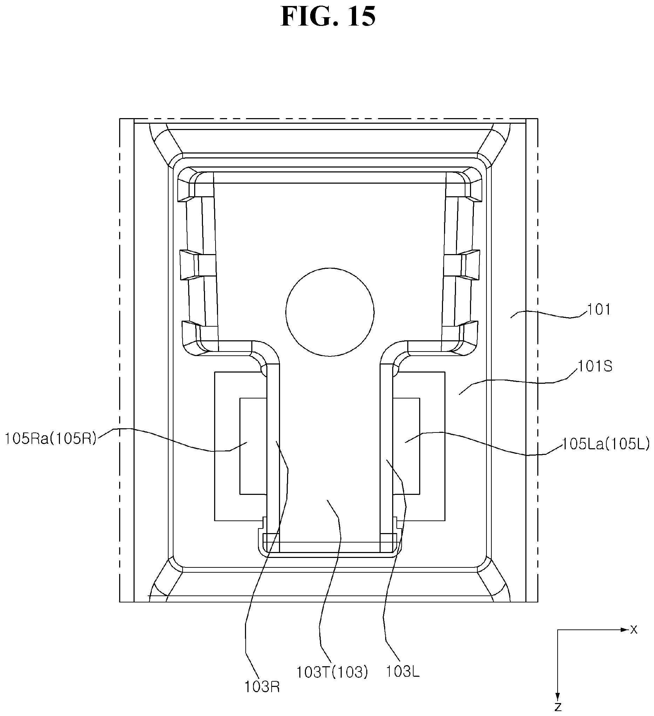

Referring to FIG. 15, the left arm 105L may extend downward from the left side 103L of the top 103T of the head 103, and the right arm 105R may extend downward from the right side 103R of the top 103T of the head 103. The left arm 105L and the right arm 105R may be aligned with each other in the leftward-rightward direction.

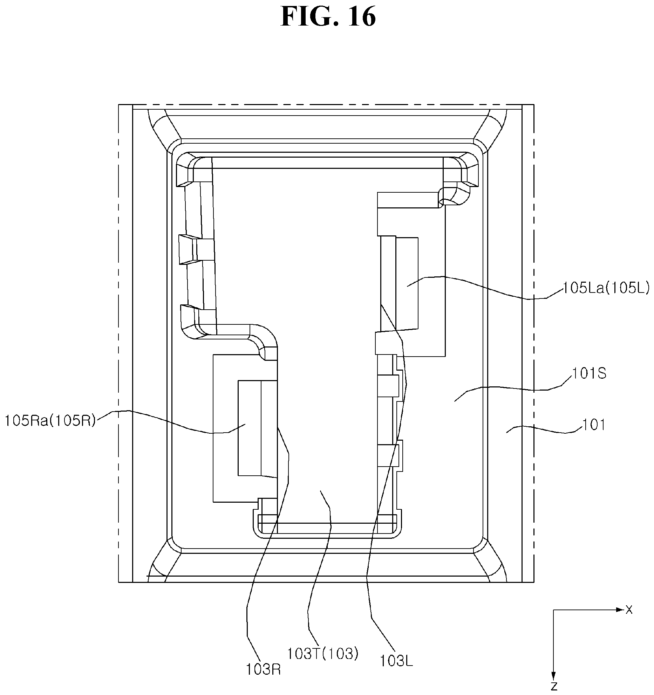

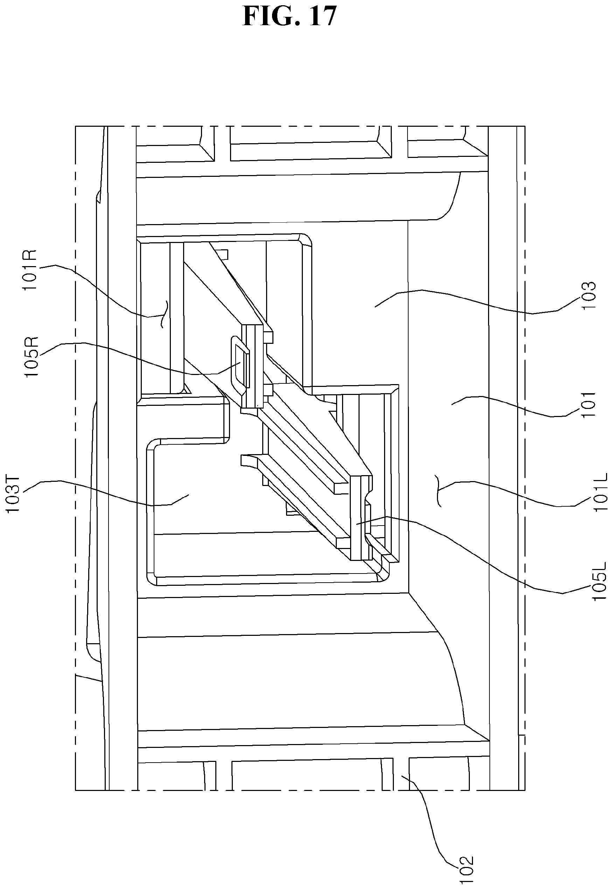

Referring to FIGs. 16 and 17, the left arm 105L may extend downward from the left side 103L of the top 103T of the head 103, and the right arm 105R may extend downward from the right side 103R of the top 103T of the head 103. The left arm 105L and the right arm 105R may be staggered from each other in the leftward-rightward direction. In this case, the spaces 101L and 101R may be more easily provided in the body 101 having a predetermined width in the leftward-rightward direction than in the case in which the left arm 105L and the right arm 105R are aligned with each other in the leftward-rightward direction.

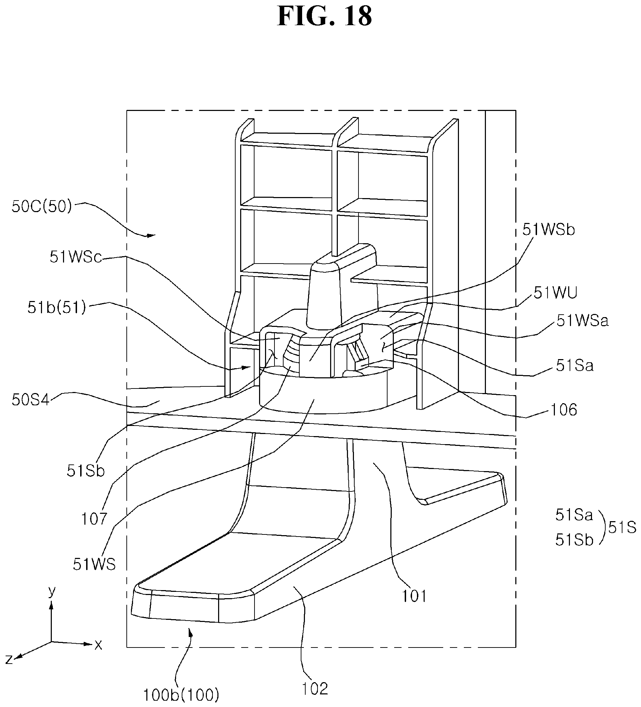

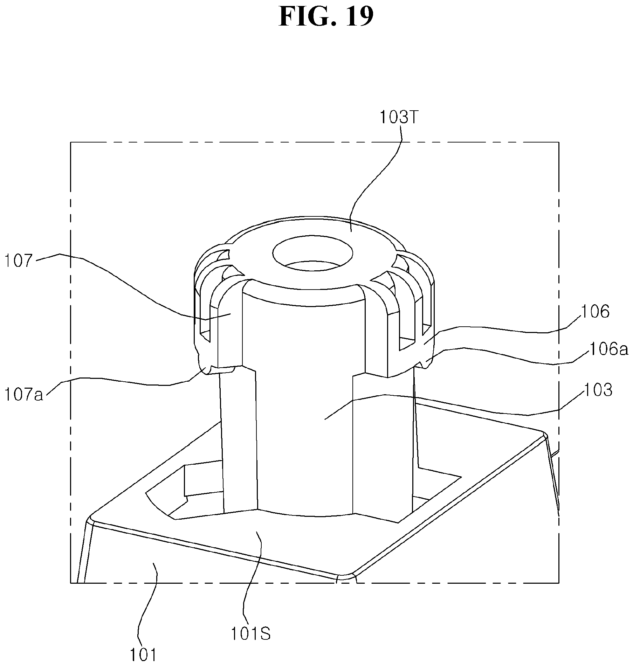

Referring to FIGs. 18 and 19, the coupling portion 51 may have a block shape protruding upward from the base 50S4, and an interior space of the coupling portion 51 may communicate with the base hole 50H. The coupling portion 51 may include a side wall 51WS and an upper wall 51WU. The side wall 51WS may form a side surface of the coupling portion 51, and at least apart of the side wall 51WS may be curved. The upper wall 51WU may form an upper surface of the coupling portion 51. A plurality of horizontal ribs and a plurality of vertical ribs may be formed around the coupling portion 51 and may be connected to the coupling portion 51. Consequently, rigidity of the coupling portion 51 may be improved. A slot 51S may be formed in the side wall 51WS. A first slot 51Sa and a second slot 51Sb may be spaced apart from each other in a circumferential direction of the side wall 51WS.

The stand 100 may include a body 101, a leg 102, a head 103, and ears 106 and 107.

The body 101 may be located under the base 50S4 and may extend in a direction intersecting the base 50S4. An upper end 101S of the body 101 may support a lower surface of the base 50S4, and may be referred to as a seating portion 101S. The leg 102 may extend from a lower end of the body 101 in a direction intersecting the body 101. The leg 102 may extend forward and rearward, and may rest on the ground. The body 101 and the leg 102 may be collectively referred to as support portions 101 and 102.

The head 103 may protrude upward from the upper end of the body 101 and may be inserted into the interior space of the coupling portion 51 through the base hole 50H of the base 50S4. The head 103 may form a step with respect to the seating portion 101S of the body 101. The head 103 may have a cylindrical shape.

The first ear 106 may protrude from a side surface of the head 103. The first ear 106 may be adjacent to the top 103T of the head 103. For example, the first ear 106 may include a plurality of ribs. A first protrusion 106a may protrude from a lower surface of the first ear 106. The first protrusion 106a may be rounded. The first protrusion 106a may be referred to as a first earlobe 106a.

The second ear 107 may protrude from the side surface of the head 103. The second ear 107 may be adjacent to the top 103T of the head 103. For example, the second ear 107 may include a plurality of ribs. A second protrusion 107a may protrude from a lower surface of the second ear 107. The second protrusion 107a may be rounded. The second protrusion 107a may be referred to as a second earlobe 107a.

The first and second ears 106 and 107 may be spaced apart from each other in a circumferential direction of the head 103. For example, the angle between the first and second ears 106 and 107 may be 135 degrees. The first ear 106 may be movably inserted into the first slot 51Sa of the coupling portion 51. The second ear 107 may be movably inserted into the second slot 51Sb of the coupling portion 51.

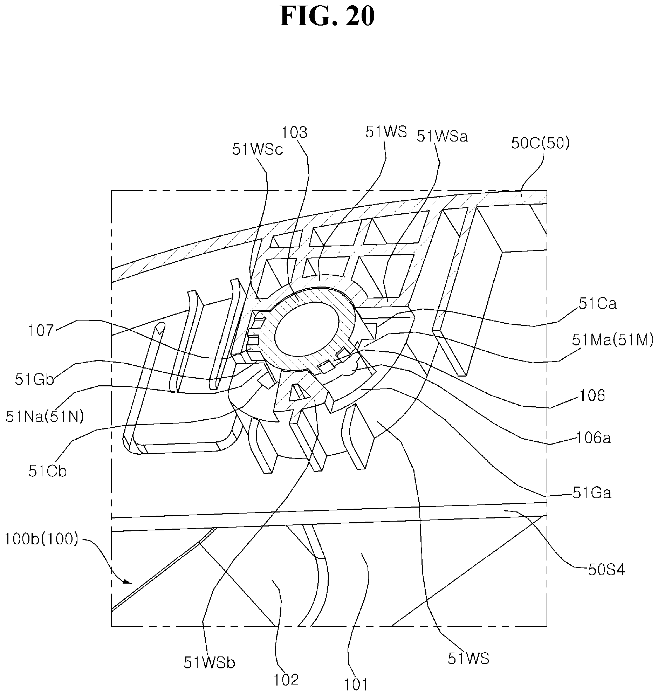

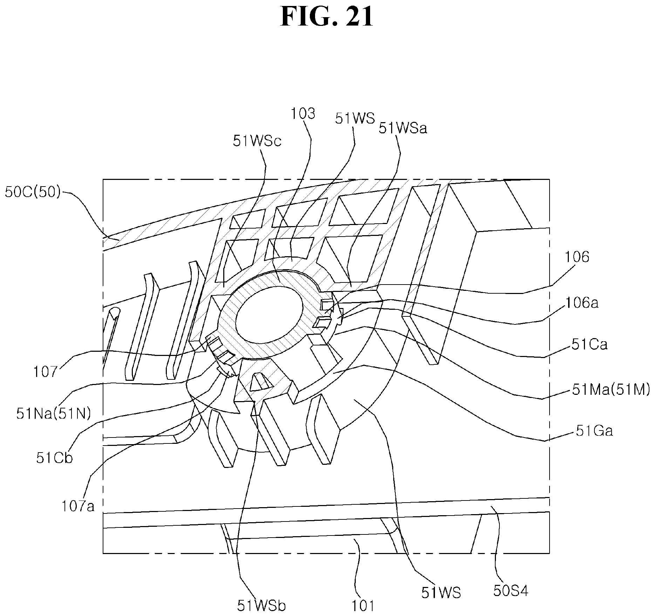

Referring to FIGs. 20 and 21, a first insertion recess 51Ga and a second insertion recess 51Gb may be formed inwardly of the side wall 51WS of the coupling portion 51 from the inner surface of the side wall 51WS, and may be spaced apart from each other in the circumferential direction of the side wall 51WS. The first insertion recess 51Ga may provide a path connecting the base hole 50H and the first slot 51Sa to each other. The second insertion recess 51Gb may provide a path connecting the base hole 50H and the second slot 51Sb to each other.

A first coupling recess 51Ca and a second coupling recess 51Cb may be formed inwardly of the side wall 51WS of the coupling portion 51 from the inner side of the side wall 51WS. The first coupling recess 51Ca may provide a path connecting the base hole 50H and the first slot 51Sa to each other, and may be adjacent to, but spaced apart from, the first insertion recess 51Ga. The second coupling recess 51Cb may provide a path connecting the base hole 50H and the second slot 51Sb to each other, and may be adjacent to, but spaced apart from, the second insertion recess 51Gb.

Referring to FIG. 20, the first ear 106 may be located in the first slot 51Sa through the base 50S4 and the first insertion recess 51Ga. A first part 51WSa and a second part 51WSb of the side wall 51WS may form both ends of the first slot 51Sa, and a side surface of the first ear 106 may reach the second part 51WSb. The second ear 107 may be located in the second slot 51Sb through the base 50S4 and the second insertion recess 51Gb. The second part 51WSb and a third part 51WSc of the side wall 51WS may form both ends of the second slot 51Sb, and a side surface of the second ear 107 may reach the third part 51WSc.

Referring to FIG. 21, a part of the bottom 51M of the first slot 51Sa may be formed between the first insertion recess 51Ga and the first coupling recess 51Ca. A part 51Na of the bottom 51N of the second slot 51Sb may be formed between the second insertion recess 51Gb and the second coupling recess 51Cb.

The user may rotate the stand 100 counterclockwise by a predetermined angle (e.g., 45 degrees). In response to rotation of the stand 100, the first protrusion 106a of the first ear 106 may be inserted into the first coupling recess 51Ca after sliding on the part 51Ma, and the second protrusion 107a of the second ear 107 may be inserted into the second coupling recess 51Cb after sliding on the part 51Na. The first protrusion 106a may be caught in the first coupling recess 51Ca, and the side surface of the first ear 106 may reach the first part 51WSa. The second protrusion 107a may be caught in the second coupling recess 51Cb, and the side surface of the second ear 107 may reach the second part 51WSb.

The user may rotate the stand 100 clockwise by a predetermined angle (e.g., 45 degrees). In response to rotation of the stand 100, the first protrusion 106a of the first ear 106 may escape from the first coupling recess 51Ca, may slide on the part 51Ma, and may be located in the first insertion recess 51Ga, and the second protrusion 107a of the second ear 107 may escape from the second coupling recess 51Cb, may slide on the part 51Na, and may be located in the second insertion recess 51Gb.

Accordingly, the stand 100 may be detachably coupled to the back cover 50 without a fastening member such as a screw, and may stably support the display device.

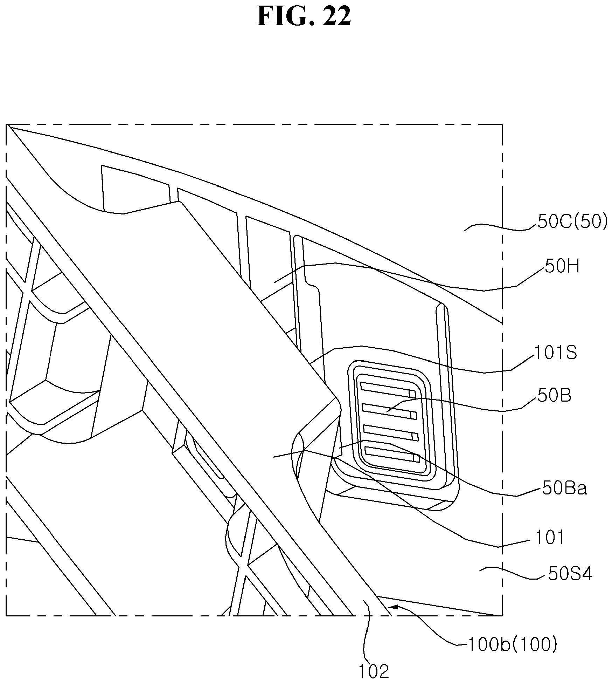

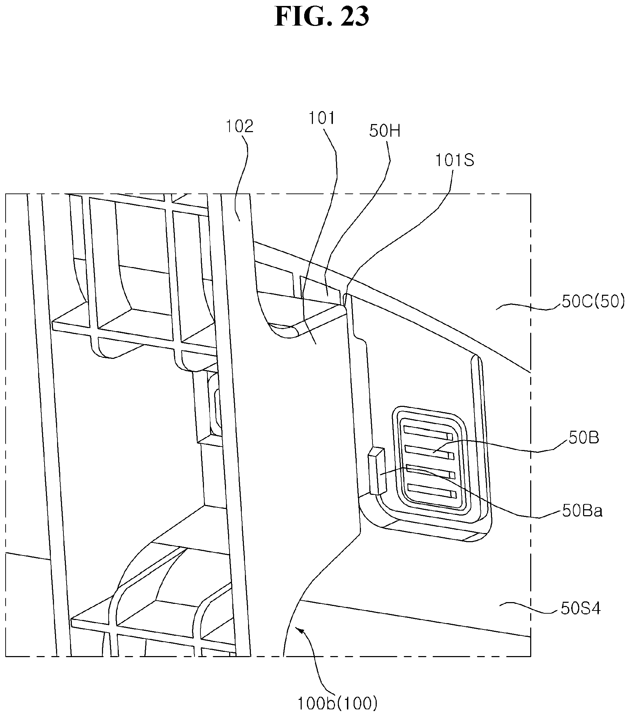

Referring to FIGs. 22 and 23, a button 50B may form a part of the base 50S4 and may be cantilevered. A protrusion 50Ba may protrude from a lower surface of the button 50B. The protrusion 50Ba may be adjacent to the base hole 50H. The protrusion 50Ba may be referred to as a stopper 50Ba.

Referring to FIGs. 20 and 22, when the first and second ears 106 and 107 of the stand 100 are inserted into the first and second insertion recesses 51Ga and 51Gb, the seating portion 101S of the body 101 may press the protrusion 50Ba and the button 50B upward.

Referring to FIGs. 21 and 23, when the stand 100 is rotated in a first rotational direction, the first and second protrusions 106a and 107a may be inserted into the first and second coupling recesses 51Ca and 51Cb. At this time, the seating portion 101S may escape from the protrusion 50Ba and the button 50B, and the protrusion 50Ba and the button 50B may be lowered to the original positions thereof. The protrusion 50Ba may interfere with the side surface of the body 101 to restrict rotation of the stand 100 in a second rotational direction opposite the first rotational direction.

The user may press the button 50B upward such that the protrusion 50Ba does not interfere with the side surface of the body 101. The user may then rotate the stand 100 in the second rotational direction and may separate the stand 100 from the back cover 50.

Referring to FIGs. 1 to 23, a display device may include a display panel, a back cover located behind the display panel and to which the display panel is coupled, and a stand coupled to a lower side of the back cover, wherein the stand may include a body having an upper end supporting the lower side of the back cover, a head protruding into the back cover from the upper end of the body, a first arm extending downward from one side of the top of the head and located in the body, the first arm having a first hook formed at an outer surface of the first arm, and a second arm extending downward from the other side of the top of the head and located in the body, the second arm having a second hook formed at an outer surface of the second arm, the back cover may include a coupling portion protruding into the back cover from the lower side of the back cover, and having an interior space accommodating the head, and the coupling portion may include a first hole formed at a side surface of the coupling portion and to which the first hook is coupled, and a second hole opposite the first hole and to which the second hook is coupled.

The first arm may extend downward from a front side of the top of the head, and the second arm may extend downward from a rear side of the top of the head.

The body may include a first space between an inner surface of a front part of the body and the first arm and a second space between an inner surface of a rear part of the body and the second arm.

The first arm and the second arm may be disposed so as to be aligned with each other or to be staggered from each other in a forward-rearward direction.

The first hole and the second hole may be located at different heights.

The coupling portion may include a front wall forming a front surface of the coupling portion and at which the first hole being is formed, a rear wall forming a rear surface of the coupling portion and at which the second hole is formed, a left wall forming a left surface of the coupling portion, a right wall forming a right surface of the coupling portion, and an upper wall forming an upper surface of the coupling portion.

The coupling portion may further include a recessed portion stepped down from the upper wall, the stand may further include a recessed portion stepped down from the top of the head, and an upper surface of the recessed portion of the stand may be in contact with a lower surface of the recessed portion of the coupling portion.

The first arm may extend downward from a front end of the recessed portion of the stand, the second arm may extend downward from a rear end of the top of the head, and the position of the second hook of the second arm may be higher than the position of the first hook of the first arm.

The back cover may include a center portion opposite the display panel and a base bent forward from a lower side of the center portion and forming the lower side of the back cover, the coupling portion may be formed on the base, and the rear wall of the coupling portion may be spaced part from the center portion in a forward direction.

The head may form a step with respect to the upper end of the body, and the stand may further include a plurality of ribs formed at an outer surface of the head and in contact with an inner surface of the coupling portion.

The back cover may include a plurality of ribs formed at an inner surface of the back cover, the ribs extending in a horizontal direction or a vertical direction, the ribs being connected to the coupling portion.

The body may extend in a direction intersecting the lower side of the back cover, and the stand may further include a leg extending from a lower end of the body in a direction intersecting the body.

The stand may include a first stand adjacent to one end of the lower side of the back cover and a second stand adjacent to the other end of the lower side of the back cover.

The effects of a display device according to the present disclosure will be described as follows.

According to at least one of the embodiments of the present disclosure, it is possible to provide a display device in which a stand can be detachably coupled to a back cover without the use of a fastening member, such as a screw.

According to at least one of the embodiments of the present disclosure, it is possible to provide a structure that can improve the coupling stability of the stand coupled to the back cover.

According to at least one of the embodiments of the present disclosure, it is possible to provide a structure that can improve the ease of assembly and disassembly of the stand.

According to at least one of the embodiments of the present disclosure, it is possible to provide various examples of the coupling structure between the back cover and stand.

An additional range of applicability of the present disclosure will be clear from the above description. Those skilled in the art will clearly appreciate that the present disclosure may be variously changed and modified without departing from the idea and scope of the present disclosure. The detailed description and specific embodiments, like preferred embodiments of the present disclosure, are therefore to be construed as illustrative.

Certain embodiments or other embodiments of the invention described above are not mutually exclusive or distinct from each other. Any or all elements of the embodiments of the invention described above may be combined with each other in configuration or function.

For example, a configuration "A" described in one embodiment of the invention and the drawings and a configuration "B" described in another embodiment of the invention and the drawings may be combined with each other. Namely, although the combination between the configurations is not directly described, the combination is possible except for the case where it is described that the combination is impossible.

The above detailed description is to be construed in all aspects as illustrative and not restrictive. The scope of the present disclosure is to be determined by reasonable interpretation of the appended claims, and all changes within the equivalent scope of the present disclosure are included in the scope of the present disclosure.

## Claims

1. A display device (1) comprising:
a display panel (10);
a back cover (50) located behind the display panel (10) and to which the display panel (10) is coupled; and
a stand (100) coupled to a lower side of the back cover (50),
wherein the stand (100) comprises:
a body (101) having an upper end (101S) supporting the lower side of the back cover (50);
a head (103) protruding into the back cover (50) from the upper end (101S) of the body (101);
a first arm (105F) extending downward from one side of a top (103T) of the head (103) and located in the body (101), the first arm (105F) having a first hook (105Fa) formed at an outer surface of the first arm (105F); and
a second arm (105B) extending downward from the other side of the top (103T) of the head (103) and located in the body (101), the second arm (105B) having a second hook (105Ba) formed at an outer surface of the second arm (105B),
wherein the back cover (50) comprises a coupling portion (51) protruding into the back cover (50) from the lower side of the back cover (50), and having an interior space accommodating the head (103), and
wherein the coupling portion (51) comprises:
a first hole (51HF) formed at a side surface of the coupling portion (51) and to which the first hook (105Fa) is coupled; and
a second hole (51HB) opposite the first hole (51HF) and to which the second hook (105Ba) is coupled.

2. The display device (1) of claim 1, wherein
the first arm (105F) extends downward from a front side of the top (103T) of the head (103), and
the second arm (105B) extends downward from a rear side of the top (103T) of the head (103).

3. The display device (1) of claim 1 or 2, wherein the body (101) comprises:
a first space (101F) between an inner surface of a front part of the body (101) and the first arm (105F); and
a second space (101B) between an inner surface of a rear part of the body (101) and the second arm (105B).

4. The display device (1) of any one of claims 1 to 3, wherein the first arm (105F) and the second arm (105B) are disposed so as to be aligned with each other or to be staggered from each other in a forward-rearward direction.

5. The display device (1) of any one of claims 1 to 4, wherein the first hole (51HF) and the second hole (51HB) are located at different heights.

6. The display device (1) of any one of claims 1 to 5, wherein the coupling portion (51) comprises:
a front wall (51WF) forming a front surface of the coupling portion (51) and at which the first hole (51HF) is formed;
a rear wall (51WB) forming a rear surface of the coupling portion (51) and at which the second hole (51HB) is formed;
a left wall (51WL) forming a left surface of the coupling portion (51);
a right wall (51WR) forming a right surface of the coupling portion (51); and
an upper wall (51WU) forming an upper surface of the coupling portion (51).

7. The display device (1) of claim 6, wherein
the coupling portion (51) further comprises a recessed portion (51P) stepped down from the upper wall (51WU),
the stand (100) further comprises a recessed portion (103P) stepped down from the top (103T) of the head (103), and
an upper surface of the recessed portion (103P) of the stand (100) is in contact with a lower surface of the recessed portion (51P) of the coupling portion (51).

8. The display device (1) of claim 7, wherein
the first arm (105F) extends downward from a front end of the recessed portion (103P) of the stand (100),
the second arm (105B) extends downward from a rear end of the top (103T) of the head (103), and
a position of the second hook (105Ba) of the second arm (105B) is higher than a position of the first hook (105Fa) of the first arm (105F).

9. The display device (1) of any one of claims 6 to 8, wherein
the back cover (50) comprises:
a center portion (50C) opposite the display panel (10); and
a base (50S4) bent forward from a lower side of the center portion (50C) and forming the lower side of the back cover (50), the coupling portion (51) is formed on the base (50S4), and
the rear wall (51WB) of the coupling portion (51) is spaced part from the center portion (50C) in a forward direction.

10. The display device (1) of any one of claims 1 to 9, wherein
the head (103) forms a step with respect to the upper end (101S) of the body (101), and
the stand (100) further comprises a plurality of ribs (103r) formed at an outer surface of the head (103) and in contact with an inner surface of the coupling portion (51).

11. The display device (1) of any one of claims 1 to 10, wherein the back cover (50) comprises a plurality of ribs formed at an inner surface of the back cover (50), extending in a horizontal direction or a vertical direction, and connected to the coupling portion (51).

12. The display device (1) of any one of claims 1 to 11, wherein
the body (101) extends in a direction intersecting the lower side of the back cover (50), and
the stand (100) further comprises a leg (102) extending from a lower end of the body (101) in a direction intersecting the body (101).

13. The display device (1) of any one of claims 1 to 12, wherein the stand (100) comprises:
a first stand (100a) adjacent to one end of the lower side of the back cover (50); and
a second stand (100b) adjacent to the other end of the lower side of the back cover (50).
